# EUROPEAN PATENT APPLICATION

(11) **EP 4 827 312 A1**
(43) Date of publication of application: **21.10.2026**
(21) Application number: 25218809.9
(22) Date of filing: 26.11.2025
(51) Int. Cl.: H10W 80/00, H10W 72/00

(54) **HYBRID BONDING ELECTRONIC COMPONENTS AND MANUFACTURING METHOD OF HYBRID BONDING ELECTRONIC COMPONENTS**

(30) Priority: 17.04.2025 KR 20250050485
(71) Applicant: Korea Advanced Institute of Science and Technology, Daejeon 34141 (KR)
(72) Inventor: CHOI, Yang-Kyu, 34141 Daejeon (KR); LEE, Do Hoon, 34141 Daejeon (KR); CHIN, Hansol, 34141 Daejeon (KR)
(74) Representative: Keller Schneider Patent- und Markenanwälte AG

(57) **Abstract**

A hybrid bonding electronic component includes a first base substrate, a first insulating layer, a plurality of first pads, a plurality of adhesive members, a second insulating layer, a plurality of second pads, and a second base substrate. The first insulating layer is disposed on the first base substrate, and has a plurality of first openings defined therein. The plurality of first pads are disposed within the plurality of first openings, each comprising a first conductive material, and each comprising an upper surface curved to have a predetermined curvature. The plurality of adhesive members are each disposed on a corresponding one of the plurality of first pads, each comprising a second conductive material different from the first conductive material, and each comprising a bottom surface having a curvature corresponding to the predetermined curvature. The second insulating layer is disposed on the first insulating layer and in contact with the first insulating layer, wherein the second insulating layer has a plurality of second openings defined therein, each exposing a corresponding adhesive member of the plurality of adhesive members. The second base substrate is disposed on the second insulating layer and the plurality of second pads.

## Description

This application claims the priority benefit of Korean Patent Application No 10-2025-0050485, filed on April 17, 2025, in the Korean Intellectual Property Office, the disclosure of which is incorporated herein by reference.

### BACKGROUND

### 1. Field of the Invention

The disclosure relates to hybrid bonding electronic components and a manufacturing method of hybrid bonding electronic components. More specifically, the disclosure relates to next-generation high-integration semiconductor packaging technology, and to a packaging technology that performs hybrid bonding by utilizing a liquid metal that exists in a liquid state at room temperature.

### 2. Description of the Related Art

The semiconductor industry has recently been developing packaging that fabricates ever-smaller electronic devices to integrate more devices and connects them by stacking in three dimensions. The most critical part in stacking is bonding that electrically/mechanically connects between pads of each device. In conventional stacking methods, there are wire bonding method that connects between metal pads with metal wires, bump method utilizing solder balls that pattern solder on metal pads to connect between pads, and micro-bump (µ-bump) method. However, with the advancement of devices, technology of hybrid bonding method has recently been attracting attention.

Hybrid bonding is a method of vertically interconnecting metal pads of two semiconductor wafers directly using heat and pressure between the pads without additional bumps. This method is considered a core technology for next-generation packaging in that it has high I/O and integration density and may significantly reduce power consumption.

For hybrid bonding, a planarization process of metal pads through chemical mechanical polishing (CMP) is essential, and after aligning the metal pads of the upper/bottom wafers at low temperature and performing TCB (Thermo-Compression Bonding), a high-temperature process of 250°C or more is used to connect between pads by utilizing metal expansion. In this case, problems such as dishing of metal pads occurring in the CMP process and misalignment during alignment between chips occur, and reliability issues occur in that the high-temperature process is required.

### SUMMARY

The disclosure aims to provide a hybrid bonding electronic component suitable for low-temperature processes at 250°C or less and capable of ensuring electrical stability between pads, by using liquid metal that exists in a liquid state at low temperatures of 100°C or less between copper pads of upper wafer and bottom wafer as an interfacial layer or interfacial bonder.

Furthermore, the technical problems to be solved by the disclosure are not limited to the above-mentioned objective, and may be extended in various forms within the scope that does not depart from the technical spirit and scope of the disclosure.

According to an embodiment of the disclosure, a hybrid bonding electronic component may include a first base substrate, a first insulating layer, a plurality of first pads, a plurality of adhesive members, a second insulating layer, a plurality of second pads, and a second base substrate. The first insulating layer may be disposed on the first base substrate, and have a plurality of first openings defined therein. The plurality of first pads may be disposed within the plurality of first openings, each comprising a first conductive material, and each comprising an upper surface curved to have a predetermined curvature. The plurality of adhesive members may be each disposed on a corresponding one of the plurality of first pads, each comprising a second conductive material different from the first conductive material, and each comprising a bottom surface having a curvature corresponding to the predetermined curvature. The second insulating layer may be disposed on the first insulating layer and in contact with the first insulating layer, wherein the second insulating layer may have a plurality of second openings defined therein, each exposing a corresponding adhesive member of the plurality of adhesive members. The second base substrate may be disposed on the second insulating layer and the plurality of second pads.

According to an embodiment of the disclosure, the first conductive material may include at least any one of copper (Cu), poly-crystalline silicon, poly-crystalline silicon doped with high concentration N-type, poly-crystalline silicon doped with high concentration P-type, tungsten (W), titanium nitride (TiN), tantalum nitride (TaN), tungsten nitride (WN), aluminum (Al), molybdenum (Mo), chromium (Cr), platinum (Pt), and titanium (Ti).

According to an embodiment of the disclosure, the second conductive material may include a metal material having a melting point of 10 degrees Celsius or more and 100 degrees Celsius or less.

According to an embodiment of the disclosure, the metal material may include at least any one of Field's metal, Rose's metal, and Wood's metal.

According to an embodiment of the disclosure, the second conductive material may include at least any one of mercury (Hg), gallium (Ga), eutectic gallium indium (EGaIn), and Galinstan.

According to an embodiment of the disclosure, each of the plurality of adhesive members may have a thickness of 0.1 micrometers or more to 5 micrometers or less.

According to an embodiment of the disclosure, each of the first insulating layer and the second insulating layer may include at least any one of silicon dioxide, aluminum oxide, hafnium oxide, hafnium oxynitride, zinc oxide, lanthanum oxide, hafnium silicon oxide, and a polymer material.

According to an embodiment of the disclosure, the hybrid bonding electronic component may further include a dummy portion disposed between the first insulating layer and the second insulating layer and comprising sodium hydroxide (NaOH).

According to an embodiment of the disclosure, each of the plurality of first pads may include a first adhesive pad having a first width and a first extension pad having a second width smaller than the first width. The first extension pad may extend from the first adhesive pad and may be disposed between the first adhesive pad and the first base substrate.

According to an embodiment of the disclosure, each of the plurality of second pads may include a second adhesive pad having a third width and a second extension pad having a fourth width smaller than the third width. The second extension pad may extend from the second adhesive pad and may be disposed between the second adhesive pad and the second base substrate.

According to an embodiment of the disclosure, surfaces of the plurality of second pads that contact the plurality of adhesive members may be flat.

According to an embodiment of the disclosure, each of surfaces of the plurality of second pads that contact the plurality of adhesive members may have a curvature smaller than the predetermined curvature.

According to an embodiment of the disclosure, each of surfaces of the plurality of second pads that contact the plurality of adhesive members may have a curvature equal to the predetermined curvature.

According to an embodiment of the disclosure, the hybrid bonding electronic component may further include a conductive interfacial layer disposed between the plurality of first pads and the plurality of second pads. The conductive interfacial layer may include at least any one of ITO (Indium Tin Oxide), PEDOT:PSS (conductive polymer), graphene, carbon nanotubes, chromium, and titanium.

According to an embodiment of the disclosure, a manufacturing method of hybrid bonding electronic components may include a preparation step, an adhesive-member placement step, a spin-coating step, and an adhesion step. In the preparation step, a first electronic component comprising a first base substrate, a first insulating layer, and a plurality of first pads may be prepared, wherein the plurality of first pads may include a first conductive material. In the adhesive-member placement step, an adhesive member may be disposed on the first electronic component, in contact with the plurality of first pads and the first insulating layer, wherein the adhesive member may include a second conductive material different from the first conductive material. In the spin-coating step, a basic material may be applied onto the first electronic component and the adhesive member by a spin-coating method, the thickness of the adhesive member may be made thinner, and a portion of the adhesive member in contact with the first insulating layer may be removed to form a plurality of adhesive members in contact with the plurality of first pads. In the adhesion step, a second electronic component comprising a second base substrate, a second insulating layer, and a plurality of second pads may be disposed on the plurality of adhesive members and the first electronic component, thereby bringing the plurality of adhesive members into contact with the plurality of second pads. Each of the plurality of first pads may include an upper surface curved to have a predetermined curvature, and the plurality of adhesive members may be in a liquid state at room temperature.

According to an embodiment of the disclosure, the first insulating layer may be disposed on the first base substrate and define a plurality of first openings, and the plurality of first pads may be respectively disposed within the plurality of first openings.

According to an embodiment of the disclosure, the second insulating layer may be disposed under the second base substrate and defines a plurality of second openings, and the plurality of second pads may be respectively disposed within the plurality of second openings.

According to an embodiment of the disclosure, the basic material may be sodium hydroxide (NaOH).

According to an embodiment of the disclosure, the first conductive material may include at least any one of copper (Cu), poly-crystalline silicon, poly-crystalline silicon doped with a high concentration of N-type dopant, poly-crystalline silicon doped with a high concentration of P-type dopant, tungsten (W), titanium nitride (TiN), tantalum nitride (TaN), tungsten nitride (WN), aluminum (Al), molybdenum (Mo), chromium (Cr), platinum (Pt), and titanium (Ti), and the second conductive material may include at least any one of mercury (Hg), gallium (Ga), eutectic gallium indium (EGaIn), and Galinstan.

According to an embodiment of the disclosure, each of the surfaces of the plurality of second pads that contact the plurality of adhesive members may have a curvature different from the predetermined curvature.

According to embodiments of the disclosure, a hybrid-bonding packaging technology using a liquid metal may effectively bond upper pad and bottom pad at a low temperature of 250 °C or less by depositing and patterning the liquid metal on metal pads in a vertical stacking process of a hybrid-bonding method.

The liquid metal may be deposited on the metal pads by using selective wetting, and, since it may be formed with a thinner thickness compared to solder used in conventional bump processes, gapless bonding may be implemented.

In addition, since the liquid metal retains flexibility and deformability even at low temperatures, problems of dishing and misalignment that occurred in conventional hybrid chip bonding (HCB) processes may be effectively addressed.

Moreover, the technology of the disclosure does not require a TCB (Thermo-Compression Bonding) process or additional heat-treatment processes, and thus may also contribute to process simplification and reduction of manufacturing costs.

### BRIEF DESCRIPTION OF THE DRAWINGS

FIG. 1A exemplarily illustrates a hybrid bonding electronic component according to an embodiment of the disclosure.
FIG. 1B exemplarily illustrates a separated configuration of the hybrid bonding electronic component illustrated in FIG. 1A.
FIG. 2 exemplarily illustrates a portion of a cross-section taken along line I-I' of FIG. 1A.
FIG. 3A exemplarily illustrates a separated configuration of the hybrid bonding electronic component of FIG. 2.
FIGS. 3B and 3C each exemplarily illustrate modified embodiments of the separated configuration of the hybrid bonding electronic component of FIG. 3A.
FIG. 4 is a flowchart of manufacturing method of a hybrid bonding electronic component according to an embodiment of the disclosure.
FIG. 5A exemplarily illustrates the preparation step of FIG.4.
FIG. 5B exemplarily illustrates the adhesive-member placement step of FIG. 4.
FIG. 5C exemplarily illustrates the spin-coating step of FIG.4.
FIG. 5D exemplarily illustrates a state after completion of the spin-coating step of FIG. 5C.
FIG. 5E exemplarily illustrates the adhesion step of FIG. 4.

### DETAILED DESCRIPTION

Hereinafter, embodiments of the disclosure will be described with reference to the drawings.

In the drawings, proportions and dimensions of components are exaggerated for effective explanation of the technical content. The term "and/or" includes all one or more combinations that may be defined by the associated configurations.

It should be understood that the terms such as "include" are intended to specify the presence of the features, numbers, steps, operations, components, parts, or combinations thereof described in the specification, but do not preclude in advance the presence or possibility of addition of one or more other features, numbers, steps, operations, elements, parts, or combinations thereof

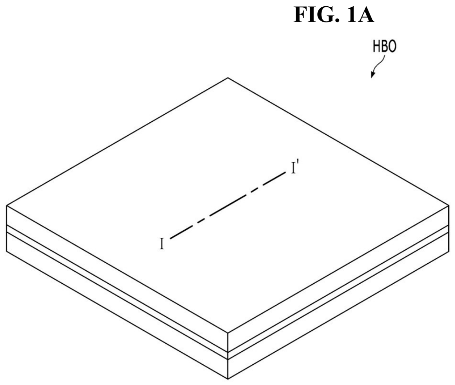

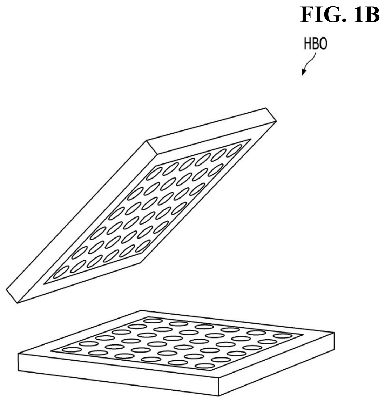

FIG. 1A exemplarily illustrates a hybrid bonding electronic component (HBO) according to an embodiment of the disclosure. FIG. 1B exemplarily illustrates a separated configuration of the hybrid bonding electronic component (HBO) illustrated in FIG. 1A.

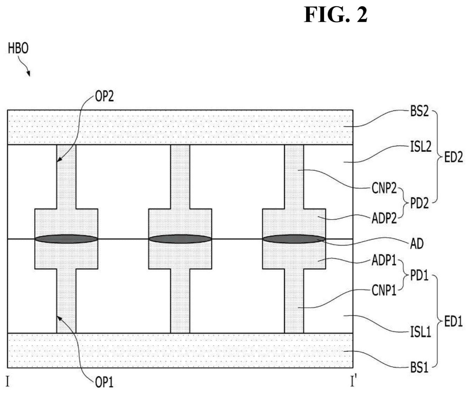

FIG. 2 exemplarily illustrates a portion of a cross-section taken along line I-I' of FIG. 1A.

Referring to Figure 2, the hybrid bonding electronic component (HBO) may include a first electronic component (ED1), a second electronic component (ED2), and a plurality of adhesive members (AD).

The first electronic component (ED1) may include a first base substrate (BS1), a first insulating layer (ISL1), and a plurality of first pads (PD1).

The first base substrate (BS 1) may be a semiconductor wafer.

The first insulating layer (ISL1) may be disposed on the first base substrate (BS1). A plurality of first openings (OP1) may be defined in the first insulating layer (ISL1). In an embodiment of the disclosure, the first insulating layer (ISL1) may include at least any one of silicon dioxide, aluminum oxide, hafnium oxide, hafnium oxynitride, zinc oxide, lanthanum oxide, hafnium silicon oxide, and a polymer material.

A plurality of first pads (PD1) may be respectively disposed in the plurality of first openings (OP1). Each of the plurality of first pads (PD1) may include an upper surface (UPS) curved to have a first curvature.

Each of the plurality of first pads (PD1) may include a first conductive material. The first conductive material may include at least any one of copper (Cu), poly-crystalline silicon, poly-crystalline silicon doped with a high concentration of N-type dopant, poly-crystalline silicon doped with a high concentration of P-type dopant, tungsten (W), titanium nitride (TiN), tantalum nitride (TaN), tungsten nitride (WN), aluminum (Al), molybdenum (Mo), chromium (Cr), platinum (Pt), and titanium (Ti).

Each of the plurality of first pads (PD1) may include a first adhesive pad (ADP1) and a first extension pad (CNP1). The first adhesive pad (ADP1) may have a first width (WD1). The first extension pad (CNP1) may extend from the first adhesive pad (ADP1) and may have a second width (WD2) smaller than the first width (WD1). The first extension pad (CNP1) may be disposed between the first adhesive pad (ADP1) and the first base substrate (BS1). Since the first adhesive pad (ADP1) has a width larger than that of the first extension pad (CNP1), the first pad (PD1) may be electrically better connected to other pads.

The plurality of adhesive members (AD) may be respectively disposed on the plurality of first pads (PD1). Each of the plurality of adhesive members (AD) may include a bottom surface (DPS) having a curvature corresponding to the first curvature. Accordingly, the plurality of adhesive members (AD) may be in close contact with the plurality of first pads (PD1).

Each of the plurality of adhesive members (AD) may include a second conductive material different from the first conductive material. The second conductive material may include a metal material having a melting point of 10 degrees Celsius or more and 100 degrees Celsius or less. For example, the metal material may include at least any one of Field's metal, Rose's metal, and Wood's metal. In addition, the second conductive material may include at least any one of mercury (Hg), gallium (Ga), eutectic gallium indium (EGaIn), and Galinstan.

A thickness of each of the plurality of adhesive members (AD) may be 0.1 micrometers or more and 5 micrometers or less.

The plurality of adhesive members (AD) may be in a liquid state at room temperature, and therefore may have a small thickness of 0.1 micrometers or more and 5 micrometers or less by utilizing selective wetting on the first pads (PD1), and may implement gapless bonding.

The second electronic component (ED2) may be disposed on the first electronic component (ED1) and the plurality of adhesive members (AD).

The second electronic component (ED2) may include a second base substrate (BS2), a second insulating layer (ISL2), and a plurality of second pads (PD2).

The second base substrate (BS2) may be a semiconductor wafer.

The second insulating layer (ISL2) may be disposed under the second base substrate (BS2). A plurality of second openings (OP2) may be defined in the second insulating layer (ISL2). In an embodiment of the disclosure, the second insulating layer (ISL2) may include at least any one of silicon dioxide, aluminum oxide, hafnium oxide, hafnium oxynitride, zinc oxide, lanthanum oxide, hafnium silicon oxide, and a polymer material.

The plurality of second pads (PD2) may be respectively disposed in the plurality of second openings (OP2). Each of the plurality of second pads (PD2) may include a bottom surface (BPS) curved to have the first curvature.

Each of the plurality of second pads (PD2) may include the first conductive material.

Each of the plurality of second pads (PD2) may include a second adhesive pad (ADP2) and a second extension pad (CNP2). The second adhesive pad (ADP2) may have a third width (WD3). The second extension pad (CNP2) may extend from the second adhesive pad (ADP2) and may have a fourth width (WD4) smaller than the third width (WD3). The second extension pad (CNP2) may be disposed between the second adhesive pad (ADP2) and the second base substrate (BS2). Since the second adhesive pad (ADP2) has a width larger than that of the second extension pad (CNP2), the second pad (PD2) may be electrically better connected to other pads.

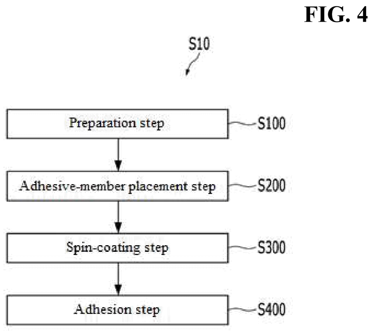

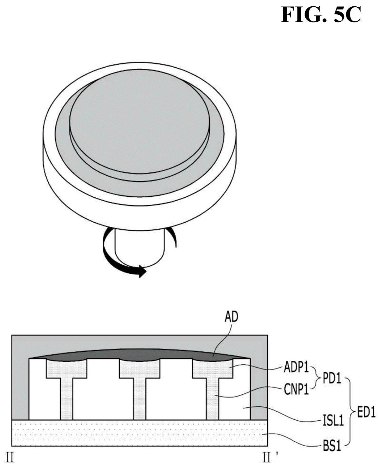

In an embodiment of the disclosure, the hybrid bonding electronic component (HBO) may further include a dummy portion (not shown) disposed between the first insulating layer (ISL1) and the second insulating layer (ISL2). The dummy portion may include sodium hydroxide (NaOH) and may be formed due to basic materials used in the spin-coating step of FIGS. 4 and 5C, which will be described below.

In an embodiment of the disclosure, the hybrid bonding electronic component (HBO) may further include a conductive interfacial layer (not shown) disposed between the plurality of first pads (PD1) and the plurality of second pads (PD2). The conductive interfacial layer may include at least any one of ITO (Indium Tin Oxide), PEDOT:PSS (conductive polymer), graphene, carbon nanotubes, chromium, and titanium.

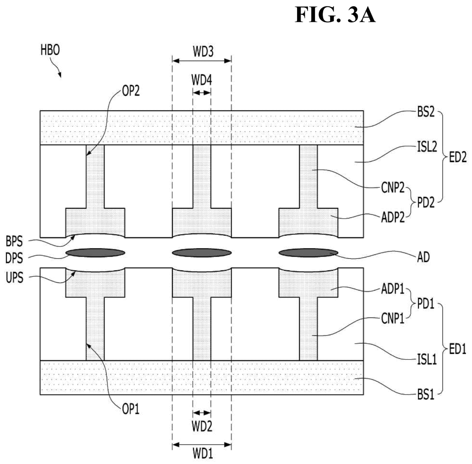

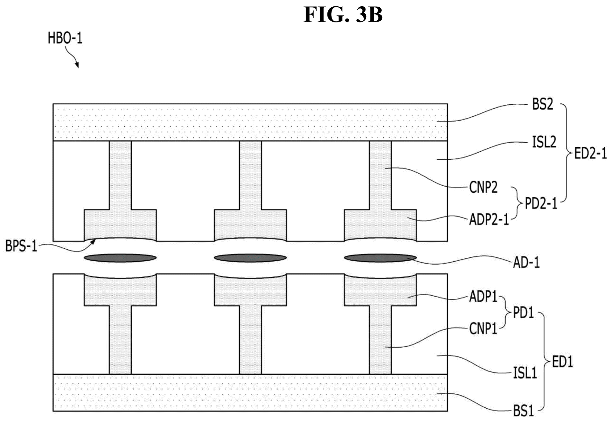

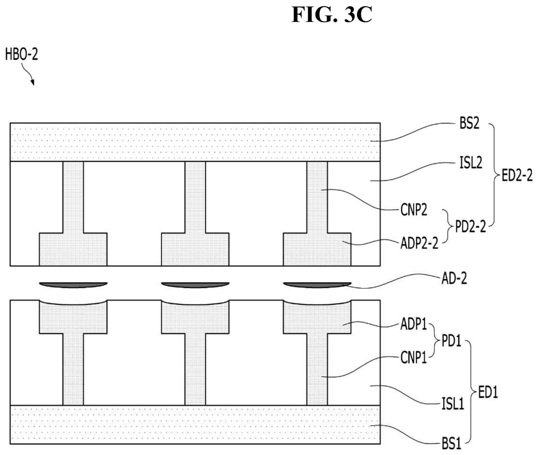

FIGS. 3B and 3C each exemplarily illustrate modified embodiments of the separated configuration of the hybrid bonding electronic component (HBO) of FIG. 3A.

Referring to FIG. 3B, the hybrid bonding electronic component (HBO-1) may include a first electronic component (ED1), a second electronic component (ED2-1), and a plurality of adhesive members (AD-1).

The second electronic component (ED2-1) may include a second base substrate (BS2), a second insulating layer (ISL2), and a plurality of second pads (PD2-1).

Each of the plurality of second pads (PD2-1) may include a bottom surface (BPS-1) curved to have a second curvature different from the first curvature.

In an embodiment of the disclosure, the second curvature may be smaller than the first curvature. That is, the bottom surface (BPS-1) of the second pad (PD2-1) shown in FIG. 3B is flatter than the bottom surface (BPS) of the second pad (PD2) shown in FIG. 3A. Accordingly, in the process where the second electronic component (ED2-1) is disposed on the first electronic component (ED1), it may be in closer contact with the plurality of adhesive members (AD-1).

Accordingly, the upper surface of each of the plurality of adhesive members (AD-1) may have the second curvature, similar to the bottom surface (BPS-1) of the second pad (PD2-1).

Other descriptions are substantially the same as those described in FIGS. 2 and 3A and will be omitted.

Referring to FIG. 3C, a hybrid bonding electronic component (HBO-2) may include a first electronic component (ED1), a second electronic component (ED2-2), and a plurality of adhesive members (AD-2).

The second electronic component (ED2-2) may include a second base substrate (BS2), a second insulating layer (ISL2), and a plurality of second pads (PD2-2).

Each of the plurality of second pads (PD2-1) may include a flat bottom surface (BPS-1). That is, unlike the bottom surface (BPS-1) of the second pad (PD2-1) shown in FIG. 3B and the bottom surface (BPS) of the second pad (PD2) shown in FIG. 3A, the bottom surface of the second pad (PD2-2) shown in FIG. 3 is flat. Accordingly, in the process where the second electronic component (ED2-2) is disposed on the first electronic component (ED1), it may be in closer contact with the plurality of adhesive members (AD-2).

Accordingly, the upper surface of each of the plurality of adhesive members (AD-2) may be flat, similar to the bottom surface (BPS-2) of the second pad (PD2-2).

Other descriptions are substantially the same as those described in FIGS. 2 and 3A and will be omitted.

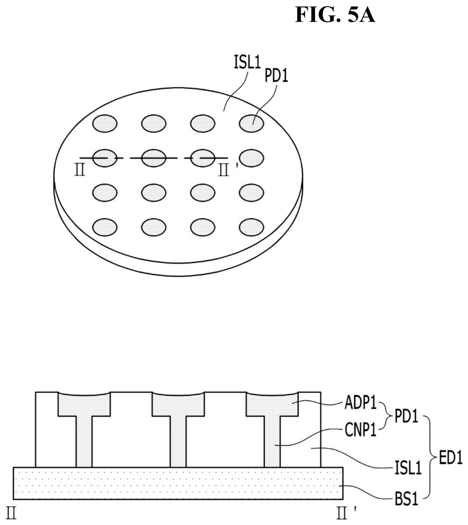

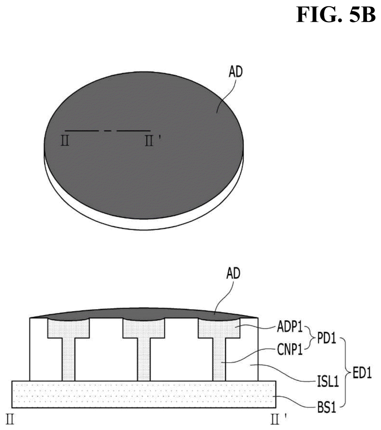

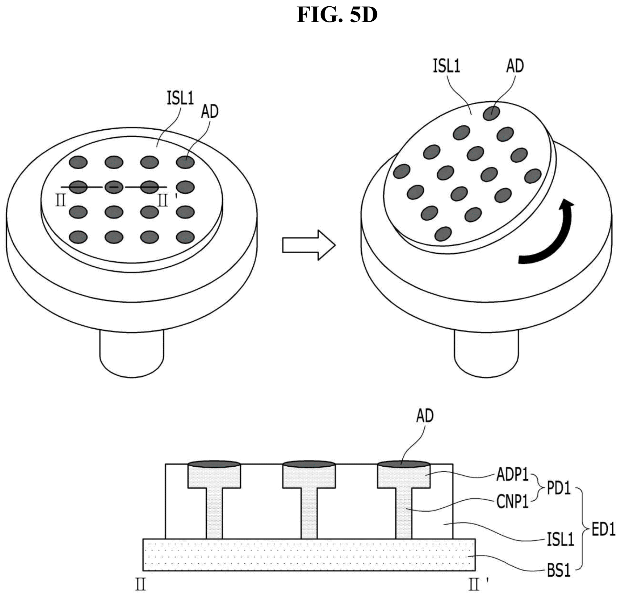

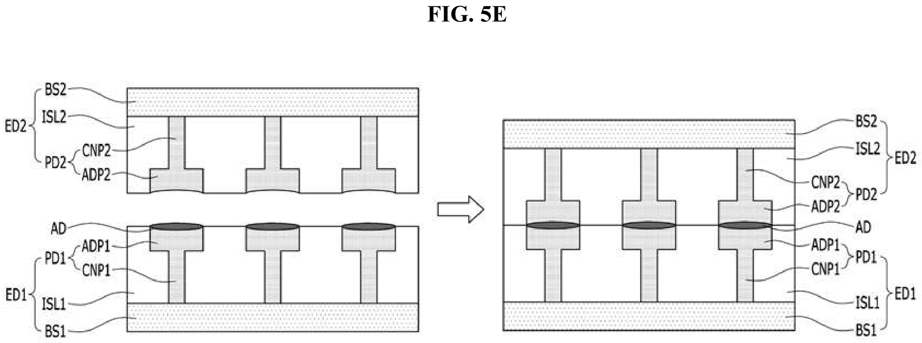

FIG. 4 is a flowchart of manufacturing method (S10) of a hybrid bonding electronic component according to an embodiment of the disclosure. FIG. 5A exemplarily illustrates the preparation step of FIG.4. FIG. 5B exemplarily illustrates the adhesive-member placement step of FIG. 4. FIG. 5C exemplarily illustrates the spin-coating step of FIG.4. FIG. 5D exemplarily illustrates a state after completion of the spin-coating step of FIG. 5C. FIG. 5E exemplarily illustrates the adhesion step of FIG. 4.

A manufacturing method (S10) of hybrid bonding electronic component may include a preparation step (S100), an adhesive-member placement step (S200), a spin-coating step (S300), and an adhesion step (S400).

Referring to FIGS. 4 and 5A, in the preparation step (S100), a first electronic component (ED1) including a first base substrate (BS1), a first insulating layer (ISL1), and a plurality of first pads (PD1) may be prepared.

Referring to FIGS. 4 and 5B, in the adhesive-member placement step (S200), an adhesive member (AD) may be disposed on a front surface of the first electronic component (ED1). In this case, the adhesive member (AD) comes into contact with the first pads (PD1) and may also partially contact the first insulating layer (ISL1).

The adhesive member (AD) may be a liquid metal. Accordingly, the adhesive member (AD) may be a metal or metal alloy having a melting point of 100 degrees Celsius or less and thus may exist in a liquid state at room temperature.

Referring to FIGS. 4 and 5C, in the spin-coating step (S300), sodium hydroxide (NaOH) may be applied onto the first electronic component (ED1) and the adhesive member (AD) by a spin-coating method. However, the disclosure is not limited thereto, and other acidic or basic materials, rather than sodium hydroxide (NaOH), may be used.

Through this, the adhesive member (AD) in liquid metal form may be deposited on the first pads (PD1) in an oxygen-free environment by removing an oxide layer on a surface of the adhesive member (AD).

Through the spin-coating step (S300), the portions of the adhesive member (AD) disposed in areas other than the first pads (PD 1) may be removed. That is, portions of the adhesive member (AD) that contact the first insulating layer (ISL1) may be removed. In addition, the thickness of the adhesive member (AD) may be controlled through the spin-coating step (S300). Furthermore, the thickness of the adhesive member (AD) can also be controlled through a pretreatment process using plasma or the like.

When depositing the adhesive member (AD) on the first pads (PD1), intermetallic wetting may be utilized. Using surface energy, the adhesive member (AD) does not wet the first insulating layer (ISL1) and selectively wets only the plurality of first pads (PD1), which have higher surface energy, thereby enabling self-patterning. Through this, the adhesive member (AD), which is a liquid metal, may be deposited on the first pads (PD1) without lithography or etching method.

Accordingly, as shown in FIG. 5D, after the spin-coating step (S300), a plurality of adhesive members (AD) may be disposed only on the first pads (PD1).

Referring to FIGS. 4 and 5E, in the adhesion step (S400), the second electronic component (ED2) may be disposed on the plurality of adhesive members (AD), and the plurality of second pads (PD2) may be brought into contact with the plurality of adhesive members (AD).

In the adhesion step (S400), a thermal process in which predetermined heat is applied, or a plasma process in which plasma is provided, may be performed. Through this, the first insulating layer (ISL1) and the second insulating layer (ISL2) may be coupled to each other.

It should be understood that, although the disclosure has been described with reference to the embodiments, those skilled in the art will be able to make various modifications and changes to the invention without departing from the spirit and scope of the invention as set forth in the following claims. In addition, the embodiments disclosed in the disclosure are not intended to limit the technical spirit of the invention, and all technical spirits within the scope of the following claims and equivalents thereof should be construed as being included in the scope of rights of the disclosure.

## Claims

1. A hybrid bonding electronic component comprising:
a first base substrate;
a first insulating layer disposed on the first base substrate and having a plurality of first openings defined therein;
a plurality of first pads disposed within the plurality of first openings, each comprising a first conductive material and each comprising an upper surface curved to have a predetermined curvature;
a plurality of adhesive members being disposed spaced apart from each other, each disposed on a corresponding one of the plurality of first pads, each comprising a second conductive material different from the first conductive material, and each comprising a bottom surface having a curvature corresponding to the predetermined curvature;
a second insulating layer disposed on the first insulating layer and in contact with the first insulating layer, the second insulating layer having a plurality of second openings defined therein, each exposing a corresponding adhesive member of the plurality of adhesive members;
a plurality of second pads disposed within the plurality of second openings, each comprising the first conductive material, and each contacting a corresponding adhesive member of the plurality of adhesive members; and
a second base substrate disposed on the second insulating layer and the plurality of second pads.

2. The hybrid bonding electronic component according to claim 1, wherein
the first conductive material comprises at least any one of copper (Cu), poly-crystalline silicon, poly-crystalline silicon doped with high concentration N-type, poly-crystalline silicon doped with high concentration P-type, tungsten (W), titanium nitride (TiN), tantalum nitride (TaN), tungsten nitride (WN), aluminum (Al), molybdenum (Mo), chromium (Cr), platinum (Pt), and titanium (Ti).

3. The hybrid bonding electronic component according to claim 2, wherein
the second conductive material comprises a metal material having a melting point of 10 degrees Celsius or more and 100 degrees Celsius or less, or
wherein
the metal material comprises at least any one of Field's metal, Rose's metal, and Wood's metal.

4. The hybrid bonding electronic component according to claim 2, wherein
the second conductive material comprises at least any one of mercury (Hg), gallium (Ga), eutectic gallium indium (EGaIn), and Galinstan, or
wherein each of the plurality of adhesive members has a thickness of 0.1 micrometers or more to 5 micrometers or less.

5. The hybrid bonding electronic component according to claim 4, wherein
each of the first insulating layer and the second insulating layer comprises at least any one of silicon dioxide, aluminum oxide, hafnium oxide, hafnium oxynitride, zinc oxide, lanthanum oxide, hafnium silicon oxide, and a polymer material.

6. The hybrid bonding electronic component according to claim 5, further comprising:
a dummy portion disposed between the first insulating layer and the second insulating layer and comprising sodium hydroxide (NaOH).

7. The hybrid bonding electronic component according to claim 6, wherein
each of the plurality of first pads comprises:
a first adhesive pad having a first width; and
a first extension pad having a second width smaller than the first width, extending from the first adhesive pad, and being disposed between the first adhesive pad and the first base substrate.

8. The hybrid bonding electronic component according to claim 7, wherein
each of the plurality of second pads comprises:
a second adhesive pad having a third width; and
a second extension pad having a fourth width smaller than the third width, extending from the second adhesive pad, and being disposed between the second adhesive pad and the second base substrate.

9. The hybrid bonding electronic component according to claim 6, wherein
surfaces of the plurality of second pads that contact the plurality of adhesive members are flat, or
wherein each of surfaces of the plurality of second pads that contact the plurality of adhesive members has a curvature smaller than the predetermined curvature.

10. The hybrid bonding electronic component according to claim 5, wherein
each of surfaces of the plurality of second pads that contact the plurality of adhesive members has a curvature equal to the predetermined curvature.

11. The hybrid bonding electronic component according to claim 5, further comprising:
a conductive interfacial layer disposed between the plurality of first pads and the plurality of second pads,
wherein the conductive interfacial layer comprises at least any one of ITO (Indium Tin Oxide), PEDOT:PSS (conductive polymer), graphene, carbon nanotubes, chromium, and titanium.

12. A manufacturing method of hybrid bonding electronic components, comprising:
a preparation step of preparing a first electronic component comprising a first base substrate, a first insulating layer, and a plurality of first pads, wherein the plurality of first pads comprise a first conductive material;
an adhesive-member placement step of disposing, on the first electronic component, an adhesive member in contact with the plurality of first pads and the first insulating layer, wherein the adhesive member comprises a second conductive material different from the first conductive material;
a spin-coating step of applying a basic material onto the first electronic component and the adhesive member by a spin-coating method, thinning a thickness of the adhesive member, and removing a portion of the adhesive member in contact with the first insulating layer to form a plurality of adhesive members in contact with the plurality of first pads; and
an adhesion step of disposing a second electronic component comprising a second base substrate, a second insulating layer, and a plurality of second pads on the plurality of adhesive members and the first electronic component to bring the plurality of adhesive members into contact with the plurality of second pads,
wherein each of the plurality of first pads comprises an upper surface curved to have a predetermined curvature, and
the plurality of adhesive members are in a liquid state at room temperature.

13. The manufacturing method of hybrid bonding electronic components according to claim 12, wherein
the first insulating layer is disposed on the first base substrate and defines a plurality of first openings, and
the plurality of first pads are respectively disposed within the plurality of first openings, or
wherein
the second insulating layer is disposed under the second base substrate and defines a plurality of second openings, and
the plurality of second pads are respectively disposed within the plurality of second openings.

14. The manufacturing method of hybrid bonding electronic components according to claim 13, wherein
the basic material is sodium hydroxide (NaOH).

15. The manufacturing method of hybrid bonding electronic components according to claim 14, wherein
the first conductive material comprises at least any one of copper (Cu), poly-crystalline silicon, poly-crystalline silicon doped with a high concentration of N-type dopant, poly-crystalline silicon doped with a high concentration of P-type dopant, tungsten (W), titanium nitride (TiN), tantalum nitride (TaN), tungsten nitride (WN), aluminum (Al), molybdenum (Mo), chromium (Cr), platinum (Pt), and titanium (Ti), and
the second conductive material comprises at least any one of mercury (Hg), gallium (Ga), eutectic gallium indium (EGaIn), and Galinstan, or
wherein each of the surfaces of the plurality of second pads that contact the plurality of adhesive members has a curvature different from the predetermined curvature.
